(19) Europäisches Patentamt
European Patent Office
Office européen des brevets

(11) **EP 1 385 270 B1**

(12) **EUROPEAN PATENT SPECIFICATION**

(45) Date of publication and mention
of the grant of the patent:
**16.05.2007 Bulletin 2007/20**

(51) Int Cl.:
**H03M 13/11** $^{(2006.01)}$

(21) Application number: **03254308.4**

(22) Date of filing: **07.07.2003**

(54) **Method and system for generating low density parity check (LDPC) codes**

Verfahren und System für die Generierung von Low Density Parity Check (LDPC) Codes

Procédé et système pour génération de code LDPC (Low Density Parity Check)

(84) Designated Contracting States:
**AT BE BG CH CY CZ DE DK EE ES FI FR GB GR HU IE IT LI LU MC NL PT RO SE SI SK TR**

(30) Priority: **26.07.2002 US 398760 P**
**28.01.2003 US 353230**

(43) Date of publication of application:
**28.01.2004 Bulletin 2004/05**

(73) Proprietor: **The DIRECTV Group, Inc.**
**El Segundo CA 90245-0956 (US)**

(72) Inventors:
• **Eroz, Mustafa**
**Germantown,**
**Maryland 20874 (US)**
• **Sun, Feng-wen**
**Germantown,**
**Maryland 20874 (US)**
• **Lee, Lin-Nan**
**Potomac,**
**Maryland 20854 (US)**

(74) Representative: **Jackson, Richard Eric et al**
**Carpmaels & Ransford,**
**43 Bloomsbury Square**
**London WC1A 2RA (GB)**

(56) References cited:
**WO-A-02/056559**

• **ELEFTHERIOU E ET AL: "Low-density parity-check codes for digital subscriber lines" PROC., IEEE INTERNATIONAL CONFERENCE ON COMMUNICATIONS, NEW YORK, NY,USA, vol. 1 OF 5, 28 April 2002 (2002-04-28) - 2 May 2002 (2002-05-02), pages 1752-1757, XP010589787 ISBN: 0-7803-7400-2**
• **ZHANG T. ET AL: "Joint code and decoder design for implementation-oriented (3, k)-regular LDPC codes" PROC., THE 35TH. ASILOMAR CONFERENCE ON SIGNALS, SYSTEMS, & COMPUTERS. PACIFIC GROOVE, CA, USA, vol. 1 OF 2. CONF. 35, 4 - 7 November 2001, pages 1232-1236, XP010582236 ISBN: 0-7803-7147-X**
• **DUMAN T.M. ET AL.: "Performance bounds for turbo-coded modulation systems" IEEE TRANSACTIONS ON COMMUNICATIONS, vol. 47, no. 4, April 1999 (1999-04), pages 511-521, XP002263494**
• **BOUTILLION E ET AL: "Decoder-first code design" PROC., 2ND INTERNATIONAL SYMPOSIUM ON TURBO CODES AND RELATED TOPICS, BREST, FRANCE, 4 - 7 September 2000, pages 459-462, XP008011934**
• **RICHARDSON T J ET AL: "Efficient encoding of low-density parity-check codes" IEEE TRANSACTIONS ON INFORMATION THEORY, IEEE INC. NEW YORK, US, vol. 47, no. 2, February 2001 (2001-02), pages 638-656, XP002965294 ISSN: 0018-9448**
• **HAGENAUER J ET AL: "Iterative decoding of binary block and convolutional codes" IEEE TRANSACTIONS ON INFORMATION THEORY, IEEE INC. NEW YORK, US, vol. 42, no. 2, March 1996 (1996-03), pages 429-445, XP000850507 ISSN: 0018-9448**

- LI XIAODONG ET AL: "Bit-interleaved coded modulation with iterative decoding using soft feedback" ELECTRONICS LETTERS, IEE STEVENAGE, GB, vol. 34, no. 10, 14 May 1998 (1998-05-14), pages 942-943, XP006009713 ISSN: 0013-5194
- TEN BRINK S ET AL: "Iterative demapping for QPSK modulation" ELECTRONICS LETTERS, IEE STEVENAGE, GB, vol. 34, no. 15, 23 July 1998 (1998-07-23), pages 1459-1460, XP006010100 ISSN: 0013-5194
- HAGENAUER J ET AL: "Decoding and equalization with analog non-linear networks" EUROPEAN TRANSACTIONS ON TELECOMMUNICATIONS, EUREL PUBLICATION, MILANO, IT, vol. 10, no. 6, November 1999 (1999-11) - December 1999 (1999-12), pages 659-680, XP002246822 ISSN: 1124-318X

**Description**

FIELD OF THE INVENTION

The present invention relates to communication systems, and more particularly to coded systems.

BACKGROUND OF THE INVENTION

Communication systems employ coding to ensure reliable communication across noisy communication channels. These communication channels exhibit a fixed capacity that can be expressed in terms of bits per symbol at certain signal to noise ratio (SNR), defining a theoretical upper limit (known as the Shannon limit). As a result, coding design has aimed to achieve rates approaching this Shannon limit. One such class of codes that approach the Shannon limit is Low Density Parity Check (LDPC) codes.

Traditionally, LDPC codes have not been widely deployed because of a number of drawbacks. One drawback is that the LDPC encoding technique is highly complex. Encoding an LDPC code using its generator matrix would require storing a very large, non-sparse matrix. Additionally, LDPC codes require large blocks to be effective; consequently, even though parity check matrices of LDPC codes are sparse, storing these matrices is problematic. From an implementation perspective, storage is an important reason why LDPC codes have not become widespread in practice. A key challenge in LDPC code implementation has been how to achieve the connection network between several processing engines (nodes) in the decoder.

Therefore, there is a need for a LDPC communication system that employs simple encoding and decoding processes. There is also a need for using LDPC codes efficiently to support high data rates, without introducing greater complexity. There is also a need to improve performance of LDPC encoders and decoders. There is a also need to minimize storage requirements for implementing LDPC coding. There is a further need for a scheme that simplifies the communication between processing nodes in the LDPC decoder.

The following publications are considered relevant to the present invention:-

Eleftheriou E. and Olger S.: "Low-density parity-check codes for digital subscriber lines", Proc., IEEE International Conference on Communications, ICC 2002, New York, NY, USA, April 28 - May 2, 2002, pages 1752-1757 (XP-10589787);

Zhang T. and Parhi K.K.: "Joint code and decoder design for implementation-oriented (3,k)-regular LDPC codes", Proc., The 35th Asilomar Conference on Signals, Systems, & Computers. Pacific Groove, CA, USA, 4 -7 Nov. 2001, IEEE Inc. New York, pages 1232-1236 (XP-105822236);

Duman T.M. and Salehi M.: "Performance bounds for turbo-coded modulation systems", IEEE Transactions on Communications, vol. 47, no. 4, April 1999, pages 511-521 (XP-2263494);

Boutillon E., Castura J. and Kschischang F.R.: "Decoder-first code design", Proc., 2nd International Symposium on Turbo Codes and Related Topics, Brest, France, 4-7 Sept. 2000, pages 459-462 (XP-8011934);

Hagenauer J. et al.: "Iterative decoding of binary block and convolutional codes", IEEE Transactions on Information Theory, vol. 42, no. 2, March 1996, pages 429-445 (XP-850507);

Hagenauer J. et al.: "Decoding and equalization with analog nonlinear networks", European Transactions on Telecommunications, EUREL Publication, Milano, vol. 10, no. 6, Nov.-Dec. 1999, pages 659-680 (XP-2246822);

Li X. and Ritcey J.A.: "Bit-interleaved coded modulation with iterative decoding using soft feedback", Electronics Letters, IEE Stevenage, vol. 34, no. 10, 14th May 1998, pages 942-943 (XP-600973); and

Vasic B. et al.: "Kirkman systems and their application in perpendicular magnetic recording", IEEE Transactions on Magnetics, vol. 38, no. 4, July 2002 (XP 2258068).

SUMMARY OF THE INVENTION

These and other needs are addressed by the present invention, wherein an approach for generating a structured Low Density Parity Check (LDPC) codes is provided. Structure of the LDPC codes is provided by restricting portion part of the parity check matrix to be lower triangular and/or satisfying other requirements such that the communication between processing nodes of the decoder becomes very simple. Also, the approach can advantageously exploit the unequal error protecting capability of LDPC codes on transmitted bits to provide extra error protection to more vulnerable bits of high order modulation constellations (such as 8-PSK (Phase Shift Keying)). Additionally, the parity check matrix can be algorithmically generated using pre-stored constants and bitwise operations.

The present invention is defined in the appendant claims.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects, all without departing from the scope of the present invention. Accordingly, the drawings and description are to be regarded as illustrative in nature, and not as restrictive.

BRIEF DESCRIPTION OF THE DRAWINGS

The present invention is illustrated by way of example, and not by way of limitation, in the figures of the accompanying drawings and in which like reference numerals refer to similar elements and in which:

FIG. 1 is a diagram of a communications system configured to utilize Low Density Parity Check (LDPC) codes, according to an embodiment of the present invention;

FIG. 2 is a diagram of an exemplary transmitter in the system of FIG. 1;

FIG. 3 is a diagram of an exemplary receiver in the system of FIG. 1;

FIG. 4 is a diagram of a sparse parity check matrix, in accordance with an embodiment of the present invention;

FIG. 5 is a diagram of a bipartite graph of an LDPC code of the matrix of FIG. 4;

FIG. 6 is a diagram of a sub-matrix of a sparse parity check matrix, wherein the sub-matrix contains parity check values restricted to the lower triangular region, according to an embodiment of the present invention;

FIG. 7 is a graph showing performance between codes utilizing unrestricted parity check matrix (H matrix) versus restricted H matrix having a sub-matrix as in FIG. 6;

FIGs. 8A and 8B are, respectively, a diagram of a non-Gray 8-PSK modulation scheme, and a Gray 8-PSK modulation, each of which can be used in the system of FIG. 1;

FIG. 9 is a graph showing performance between codes utilizing Gray labeling versus non-Gray labeling;

FIG. 10 is a flow chart of the operation of the LDPC decoder using non-Gray mapping, according to an embodiment of the present invention;

FIG. 11 is a flow chart of the operation of the LDPC decoder of FIG. 3 using Gray mapping, according to an embodiment of the present invention;

FIGs. 12A-12C are diagrams of the interactions between the check nodes and the bit nodes in a decoding process, according to an embodiment of the present invention;

FIGs. 13A-13C are graphs showing simulation results of LDPC codes generated in accordance with various embodiments of the present invention;

FIGS. 14A and 14B are diagrams of the top edge and bottom edge, respectively, of memory organized to support structured access as to realize randomness in LDPC coding, according to an embodiment of the present invention; and

FIG. 15 is a diagram of a computer system that can perform the processes of encoding and decoding of LDPC codes, in accordance with embodiments of the present invention.

DESCRIPTION OF THE PREFERRED EMBODIMENT

A system, method, and software for efficiently generating structured Low Density Parity Check (LDPC) codes are described. In the following description, for the purposes of explanation, numerous specific details are set forth in order to provide a thorough understanding of the present invention. It is apparent, however, to one skilled in the art that the present invention may be practiced without these specific details or with an equivalent arrangement. In other instances, well-known structures and devices are shown in block diagram form in order to avoid unnecessarily obscuring the present invention.

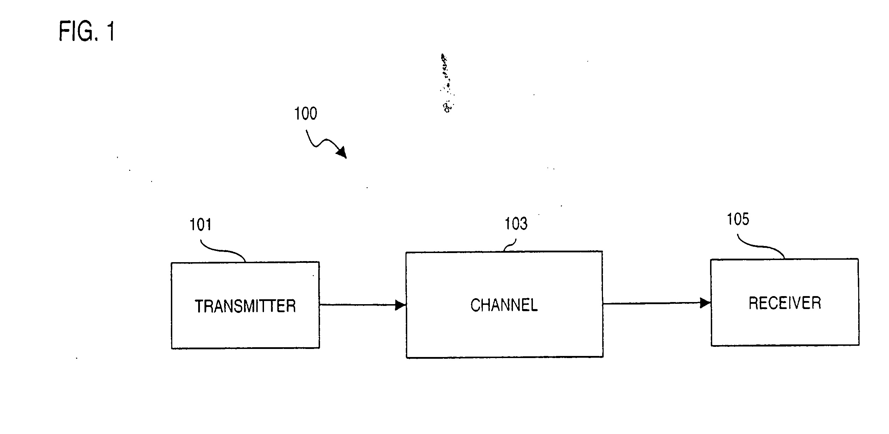

FIG. 1 is a diagram of a communications system configured to utilize Low Density Parity Check (LDPC) codes, according to an embodiment of the present invention. A digital communications system 100 includes a transmitter 101 that generates signal waveforms across a communication channel 103 to a receiver 105. In this discrete communications system 100, the transmitter 101 has a message source that produces a discrete set of possible messages; each of the possible messages has a corresponding signal waveform. These signal waveforms are attenuated, or otherwise altered, by communications channel 103. To combat the noise channel 103, LDPC codes are utilized.

The LDPC codes that are generated by the transmitter 101 enables high speed implementation without incurring any performance loss. These structured LDPC codes output from the transmitter 101 avoid assignment of a small number of check nodes to the bit nodes already vulnerable to channel errors by virtue of the modulation scheme (e.g., 8-PSK).

Such LDPC codes have a parallelizable decoding algorithm (unlike turbo codes), which advantageously involves simple operations such as addition, comparison and table look-up. Moreover, carefully designed LDPC codes do not exhibit any sign of error floor.

According to one embodiment of the present invention, the transmitter 101 generates, using a relatively simple encoding technique, LDPC codes based on parity check matrices (which facilitate efficient memory access during decoding) to communicate with the receiver 105. The transmitter 101 employs LDPC codes that can outperform concatenated turbo+RS (Reed-Solomon) codes, provided the block length is sufficiently large.

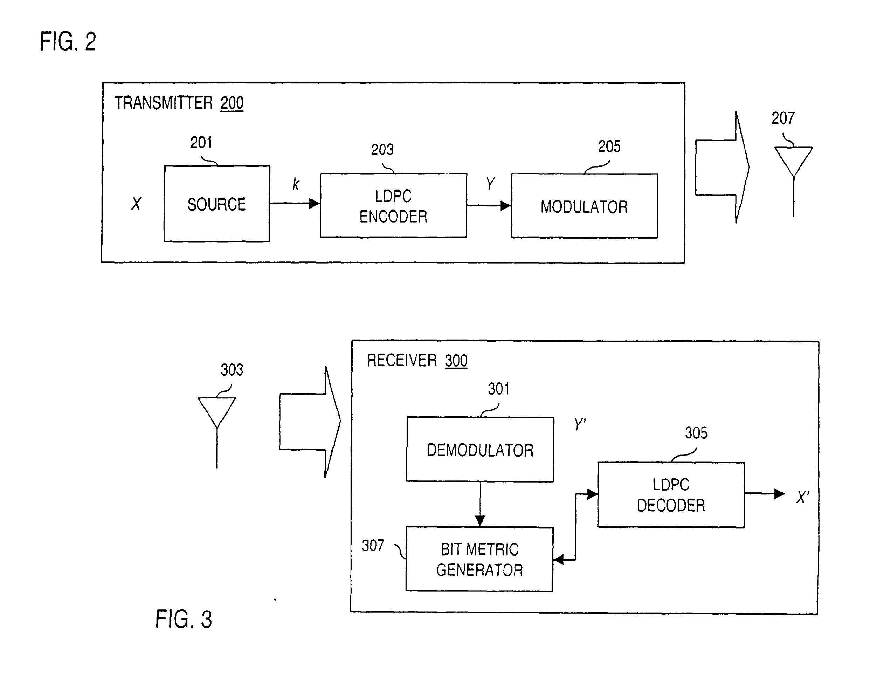

FIG. 2 is a diagram of an exemplary transmitter in the system of FIG. 1. A transmitter 200 is equipped with an LDPC encoder 203 that accepts input from an information source 201 and outputs coded stream of higher redundancy suitable for error correction processing at the receiver 105. The information source 201 generates $k$ signals from a discrete alphabet, $X$. LDPC codes are specified with parity check matrices. On the other hand, encoding LDPC codes require, in general, specifying the generator matrices. Even though it is possible to obtain generator matrices from parity check matrices using Gaussian elimination, the resulting matrix is no longer sparse and storing a large generator matrix can be complex.

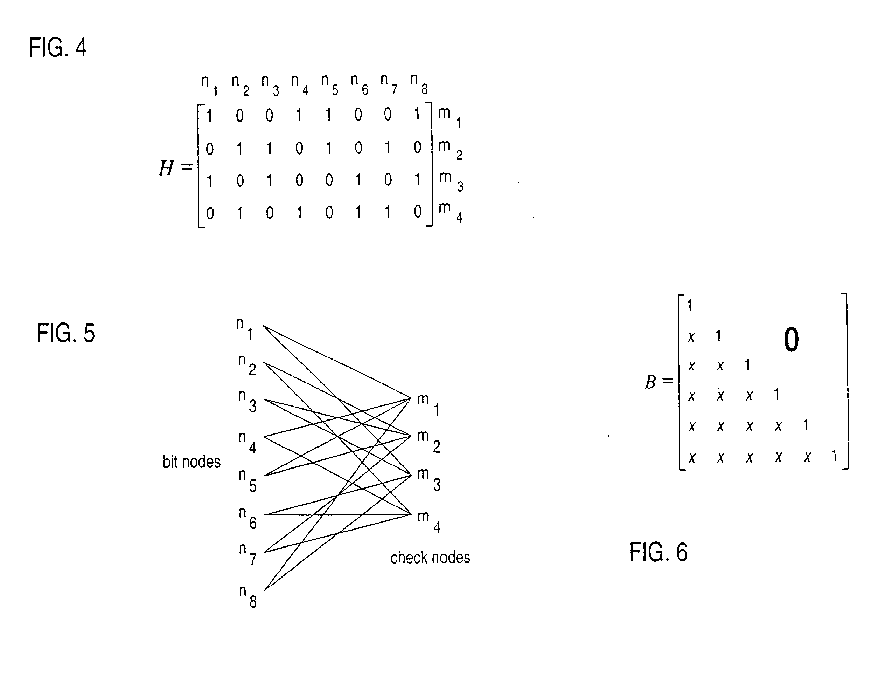

Encoder 203 generates signals from alphabet $Y$ to a modulator 205 using a simple encoding technique that makes use of only the parity check matrix by imposing structure onto the parity check matrix. Specifically, a restriction is placed on the parity check matrix by constraining certain portion of the matrix to be triangular. The construction of such a parity check matrix is described more fully below in FIG. 6. Such a restriction results in negligible performance loss, and therefore, constitutes an attractive trade-off.

Modulator 205 maps the encoded messages from encoder 203 to signal waveforms that are transmitted to a transmit antenna 207, which emits these waveforms over the communication channel 103. Accordingly, the encoded messages are modulated and distributed to a transmit antenna 207. The transmissions from the transmit antenna 207 propagate to a receiver, as discussed below.

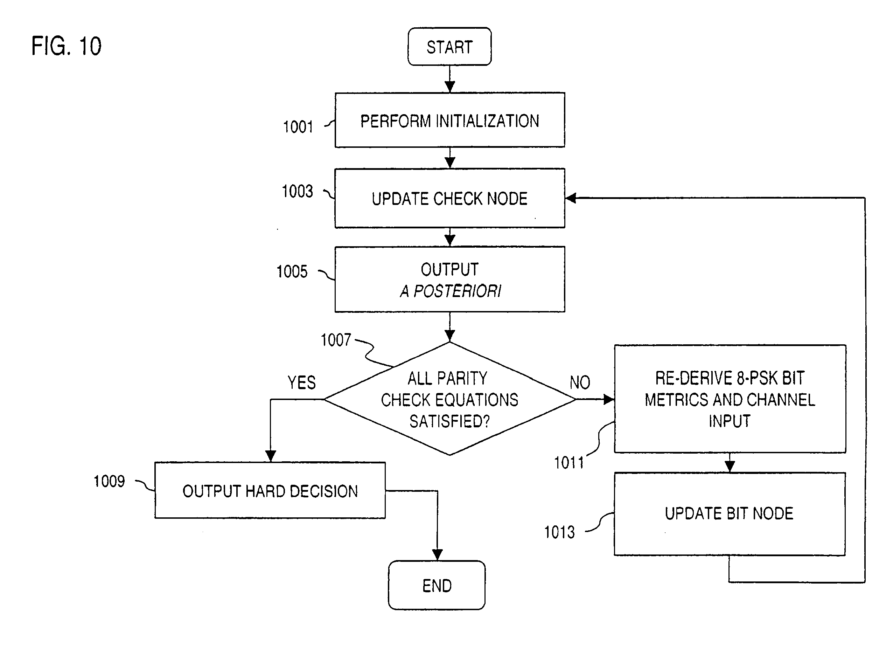

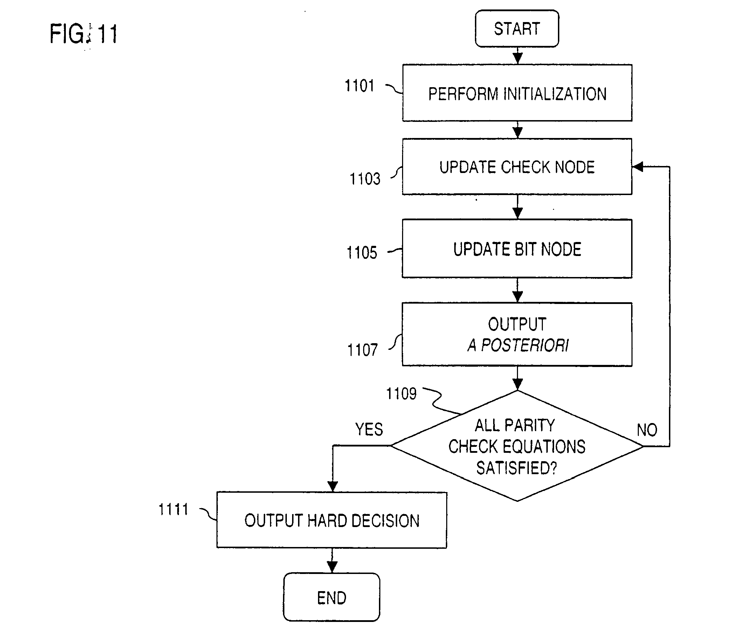

FIG. 3 is a diagram of an exemplary receiver in the system of FIG. 1. At the receiving side, a receiver 300 includes a demodulator 301 that performs demodulation of received signals from transmitter 200. These signals are received at a receive antenna 303 for demodulation. After demodulation, the received signals are forwarded to a decoder 305, which attempts to reconstruct the original source messages by generating messages, $X'$, in conjunction with a bit metric generator 307. With non-Gray mapping, the bit metric generator 307 exchanges probability information with the decoder 305 back and forth (iteratively) during the decoding process, which is detailed in FIG. 10. Alternatively, if Gray mapping is used (according to one embodiment of the present invention), one pass of the bit metric generator is sufficient, in which further attempts of bit metric generation after each LDPC decoder iteration are likely to yield limited performance improvement; this approach is more fully described with respect to FIG. 11. To appreciate the advantages offered by the present invention, it is instructive to examine how LDPC codes are generated, as discussed in FIG. 4.

FIG. 4 is a diagram of a sparse parity check matrix, in accordance with an embodiment of the present invention. LDPC codes are long, linear block codes with sparse parity check matrix $H_{(n-k) \times n}$. Typically the block length, $n$, ranges from thousands to tens of thousands of bits. For example, a parity check matrix for an LDPC code of length $n$=8 and rate ½ is shown in FIG. 4. The same code can be equivalently represented by the bipartite graph, per FIG. 5.

FIG. 5 is a diagram of a bipartite graph of an LDPC code of the matrix of FIG. 4. Parity check equations imply that for each check node, the sum (over GF (Galois Field)(2)) of all adjacent bit nodes is equal to zero. As seen in the figure, bit nodes occupy the left side of the graph and are associated with one or more check nodes, according to a predetermined relationship. For example, corresponding to check node $m_1$, the following expression exists $n_1 + n_4 + n_5 + n_8 = 0$ with respect to the bit nodes.

Returning the receiver 303, the LDPC decoder 305 is considered a message passing decoder, whereby the decoder 305 aims to find the values of bit nodes. To accomplish this task, bit nodes and check nodes iteratively communicate with each other. The nature of this communication is described below.

From check nodes to bit nodes, each check node provides to an adjacent bit node an estimate ("opinion") regarding the value of that bit node based on the information coming from other adjacent bit nodes. For instance, in the above example if the sum of $n_4$, $n_5$ and $n_8$ "looks like" 0 to $m_1$, then $m_1$ would indicate to $n_1$ that the value of $n_1$ is believed to be 0 (since $n_1 + n_4 + n_5 + n_8 = 0$ ); otherwise $m_1$ indicate to $n_1$ that the value of $n_1$ is believed to be 1. Additionally, for soft decision decoding, a reliability measure is added.

From bit nodes to check nodes, each bit node relays to an adjacent check node an estimate about its own value based on the feedback coming from its other adjacent check nodes. In the above example $n_1$ has only two adjacent check nodes $m_1$ and $m_3$. If the feedback coming from $m_3$ to $n_1$ indicates that the value of $n_1$ is probably 0, then $n_1$ would notify $m_1$ that an estimate of $n_1$'s own value is 0. For the case in which the bit node has more than two adjacent check nodes, the bit node performs a majority vote (soft decision) on the feedback coming from its other adjacent check nodes before reporting that decision to the check node it communicates. The above process is repeated until all bit nodes are considered to be correct (i.e., all parity check equations are satisfied) or until a predetermined maximum number of iterations is reached, whereby a decoding failure is declared.

FIG. 6 is a diagram of a sub-matrix of a sparse parity check matrix, wherein the sub-matrix contains parity check values restricted to the lower triangular region, according to an embodiment of the present invention. As described previously, the encoder 203 (of FIG. 2) can employ a simple encoding technique by restricting the values of the lower triangular area of the parity check matrix. According to an embodiment of the present invention, the restriction imposed on the parity check matrix is of the form:

$$H_{(n-k)xn} = [A_{(n-k)xk} \ B_{(n-k)x(n-k)}]$$

, where $B$ is lower triangular.

Any information block $i = (i_0, i_1,..., i_{k-1})$ is encoded to a codeword $c = (i_0, i_1,...,i_{k-1}, p_0, p_1,...p_{n-k-1})$ using $\mathbf{Hc^T = 0,}$ and recursively solving for parity bits; for example,

$$a_{00}i_0 + a_{01}i_1 + ... + a_{0,k-1}i_{k-1} + p_0 = 0 \Rightarrow Solve \ p_0 \qquad ,$$

$$a_{10}i_0 + a_{11}i_1 + ... + a_{1,k-1}i_{k-1} + b_{10}p_0 + p_1 = 0 \Rightarrow Solve \ p_1$$

and similarly for $p_2, p_3,...,p_{n-k-1}$.

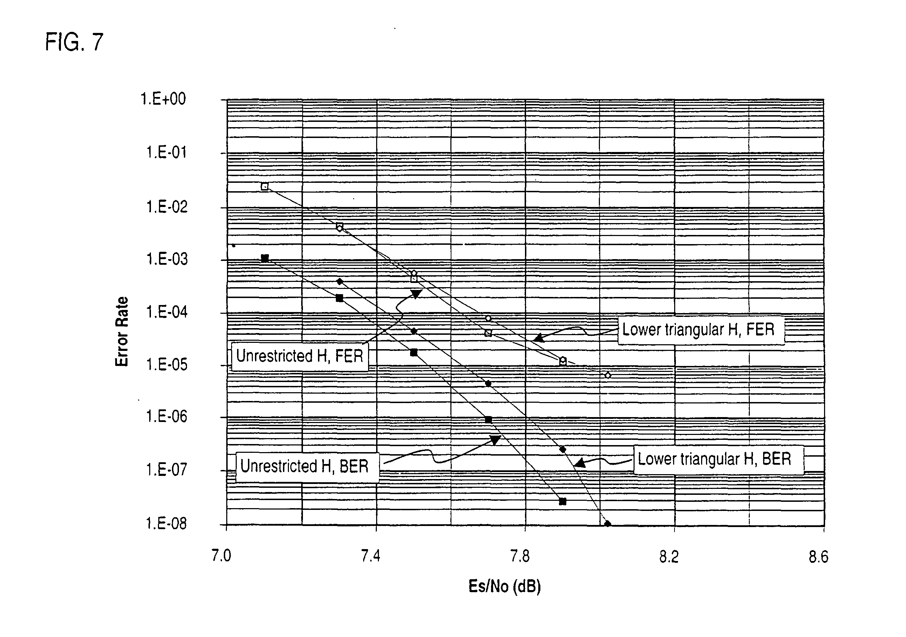

FIG. 7 is a graph showing performance between codes utilizing unrestricted parity check matrix (H matrix) versus restricted H matrix of FIG. 6. The graph shows the performance comparison between two LDPC codes: one with a general parity check matrix and the other with a parity check matrix restricted to be lower triangular to simplify encoding. The modulation scheme, for this simulation, is 8-PSK. The performance loss is within 0.1 dB. Therefore, the performance loss is negligible based on the restriction of the lower triangular H matrices, while the gain in simplicity of the encoding technique is significant. Accordingly, any parity check matrix that is equivalent to a lower triangular or upper triangular under row and/or column permutation can be utilized for the same purpose.

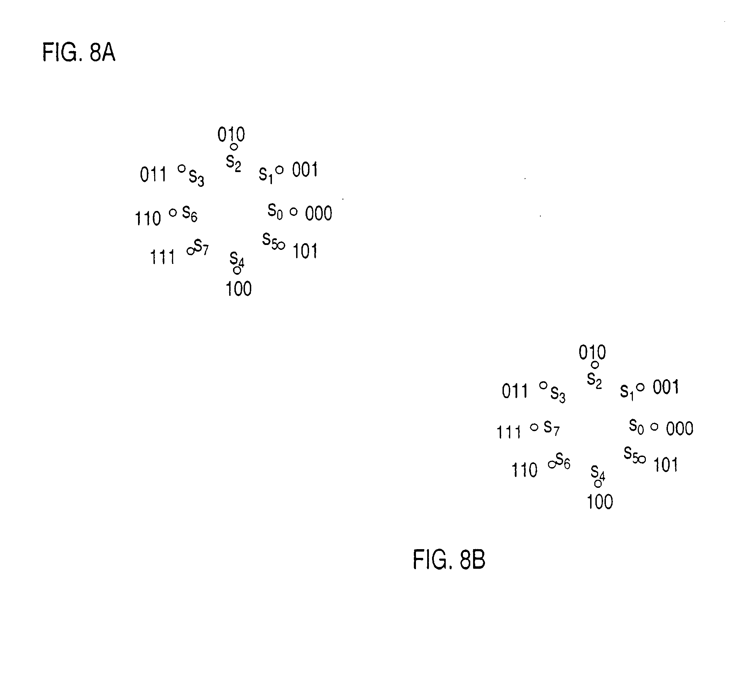

FIGs. 8A and 8B are, respectively, a diagram of a non-Gray 8-PSK modulation scheme, and a Gray 8-PSK modulation, each of which can be used in the system of FIG. 1. The non-Gray 8-PSK scheme of FIG. 8A can be utilized in the receiver of FIG. 3 to provide a system that requires very low Frame Erasure Rate (FER). This requirement can also be satisfied by using a Gray 8-PSK scheme, as shown in FIG. 8B, in conjunction with an outer code, such as Bose, Chaudhuri, and Hocquenghem (BCH), Hamming, or Reed-Solomon (RS) code.

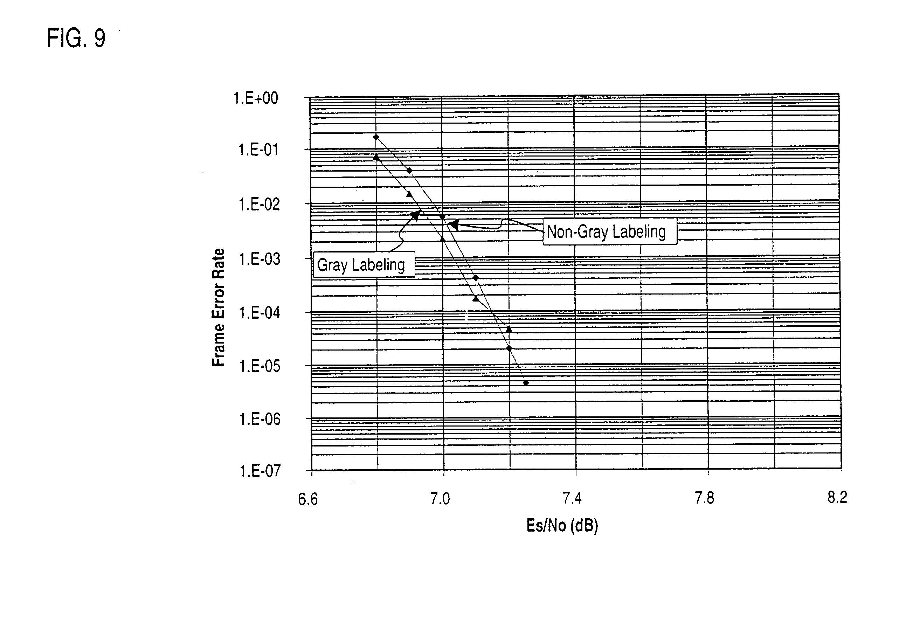

Alternatively, the Gray 8-PSK scheme of FIG. 8B can be implemented with an outer code. Under this scheme, there is no need to iterate between the LDPC decoder 305 (FIG. 3) and the bit metric generator 307, which may employ 8-PSK modulation. In the absence of an outer code, the LDPC decoder 305 using Gray labeling exhibit an earlier error floor, as shown in FIG. 9 below.

FIG. 9 is a graph showing performance between codes utilizing Gray labeling versus non-Gray labeling of FIGs. 8A and 8B. The error floor stems from the fact that assuming correct feedback from LDPC decoder 305, regeneration of 8-PSK bit metrics is more accurate with non-Gray labeling since the two 8-PSK symbols with known two bits are further apart with non-Gray labeling. This can be equivalently seen as operating at higher Signal-to-Noise Ratio (SNR). Therefore, even though error asymptotes of the same LDPC code using Gray or non-Gray labeling have the same slope (i.e., parallel to each other), the one with non-Gray labeling passes through lower FER at any SNR.

On the other hand, for systems that do not require very low FER, Gray labeling without any iteration between LDPC decoder 305 and 8-PSK bit metric generator 307 may be more suitable because re-generating 8-PSK bit metrics before every LDPC decoder iteration causes additional complexity. Moreover, when Gray labeling is used, re-generating 8-PSK bit metrics before every LDPC decoder iteration yields only very slight performance improvement. As mentioned previously, Gray labeling without iteration may be used for systems that require very low FER, provided an outer code is implemented.

The choice between Gray labeling and non-Gray labeling depends also on the characteristics of the LDPC code. Typically, the higher bit or check node degrees, the better it is for Gray labeling, because for higher node degrees, the initial feedback from LDPC decoder 305 to 8-PSK (or similar higher order modulation) bit metric generator 307 deteriorates more with non-Gray labeling.

When 8-PSK (or similar higher order) modulation is utilized with a binary decoder, it is recognized that the three (or more) bits of a symbol are not received "equally noisy". For example with Gray 8-PSK labeling, the third bit of a symbol is considered more noisy to the decoder than the other two bits. Therefore, the LDPC code design does not assign a small number of edges to those bit nodes represented by "more noisy" third bits of 8-PSK symbol so that those bits are not penalized twice.

FIG. 10 is a flow chart of the operation of the LDPC decoder using non-Gray mapping, according to an embodiment of the present invention. Under this approach, the LDPC decoder and bit metric generator iterate one after the other. In this example, 8-PSK modulation is utilized; however, the same principles apply to other higher modulation schemes as well. Under this scenario, it is assumed that the demodulator 301 outputs a distance vector, **d**, denoting the distances between received noisy symbol points and 8-PSK symbol points to the bit metric generator 307, whereby the vector components are as follows:

$$d_i = -\frac{E_s}{N_0}\{(r_x - s_{i,x})^2 + (r_y - s_{i,y})^2\} \qquad i = 0,1,...7 .$$

The 8-PSK bit metric generator 307 communicates with the LDPC decoder 305 to exchange *a priori* probability information and *a posteriori* probability information, which respectively are represented as **u**, and **a**. That is, the vectors **u** and **a** respectively represent *a priori* and *a posteriori* probabilities of log likelihood ratios of coded bits.

The 8-PSK bit metric generator 307 generates the *a priori* likelihood ratios for each group of three bits as follows. First, extrinsic information on coded bits is obtained:

$$e_j = a_j - u_j \qquad j = 0,1,2 .$$

Next, 8-PSK symbol probabilities, $p_i\, i = 0,1,...,7$ , are determined.
* $y_j = -f(0,e_j)\, j = 0,1,2$ where $f(a,b) = \max(a,b) + LUT_f(a,b)$ with $LUT_f(a,b) = \ln(1 + e^{-|a-b|})$

$$* x_j = y_j + e_j \qquad j = 0,1,2$$

$$* p_0 = x_0 + x_1 + x_2 \qquad p_4 = y_0 + x_1 + x_2$$

$$p_1 = x_0 + x_1 + y_2 \qquad p_5 = y_0 + x_1 + y_2$$

$$p_2 = x_0 + y_1 + x_2 \qquad p_6 = y_0 + y_1 + x_2$$

$$p_3 = x_0 + y_1 + y_2 \qquad p_7 = y_0 + y_1 + y_2$$

Next, the bit metric generator 307 determines *a priori* log likelihood ratios of the coded bits as input to LDPC decoder 305, as follows:

$$u_0 = f(d_0 + p_0, d_1 + p_1, d_2 + p_2, d_3 + p_3) - f(d_4 + p_4, d_5 + p_5, d_6 + p_6, d_7 + p_7) - e_0$$

$$u_1 = f(d_0 + p_0, d_1 + p_1, d_4 + p_4, d_5 + p_5) - f(d_2 + p_2, d_3 + p_3, d_6 + p_6, d_7 + p_7) - e_1$$

$$u_2 = f(d_0 + p_0, d_2 + p_2, d_4 + p_4, d_6 + p_6) - f(d_1 + p_1, d_3 + p_3, d_5 + p_5, d_7 + p_7) - e_2$$

It is noted that the function $f(.)$ with more than two variables can be evaluated recursively; e.g. $f(a,b,c) = f(f(a,b),c)$.

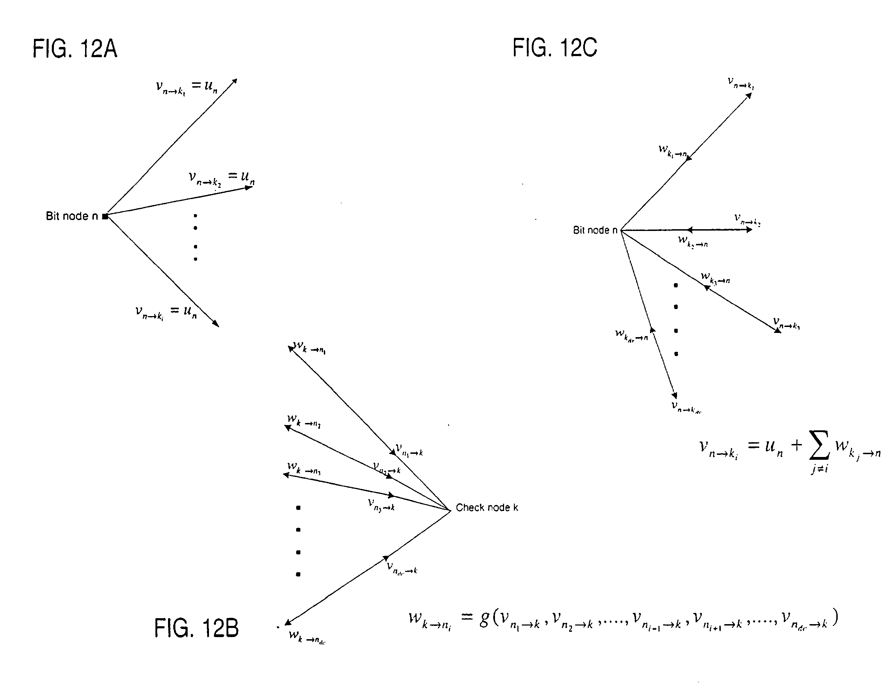

The operation of the LDPC decoder 305 utilizing non-Gray mapping is now described. In step 1001, the LDPC decoder 305 initializes log likelihood ratios of coded bits, $v$, before the first iteration according to the following (and as shown in FIG. 12A): $v_{n \to k_i} = u_n$, $n = 0,1,..., N - 1$, $i = 1,2,...,$ deg(*bit node n*)
Here, $v_{n \to k_i}$ denotes the message that goes from bit node $n$ to its adjacent check node $k_i$, $u_n$ denotes the demodulator output for the bit $n$ and $N$ is the codeword size.

In step 1003, a check node, $k$, is updated, whereby the input $v$ yields the output $w$. As seen in FIG. 12B, the incoming messages to the check node $k$ from its $d_c$ adjacent bit nodes are denoted by $v_{n_1 \to k}, v_{n_2 \to k},..., v_{n_{dc} \to k}$. The goal is to compute the outgoing messages from the check node $k$ back to $d_c$ adjacent bit nodes. These messages are denoted

by $w_{k \to n_1}$, $w_{k \to n_2}$ ,...., $w_{k \to ndc}$, where

$$w_{k \to n_i} = g(v_{n_1 \to k}, v_{n_2 \to k}, ...., v_{n_{i-1} \to k}, v_{n_{i+1} \to k}, ...., v_{n_{dc} \to k}).$$

The function $g(\ )$ is defined as follows:

$$g(a,b) = sign(a) \times sign(b) \times \{\min(|a|,|b|)\} + LUT_g(a,b),$$

where $LUT_g(a,b) = \ln(1 + e^{-|a+b|}) - \ln(1 + e^{-|a-b|})$. Similar to function $f$, function $g$ with more than two variables can be evaluated recursively.

Next, the decoder 305, per step 1205, outputs *a posteriori* probability information (FIG. 12C), such that:

$$a_n = u_n + \sum_j w_{k_j \to n}$$

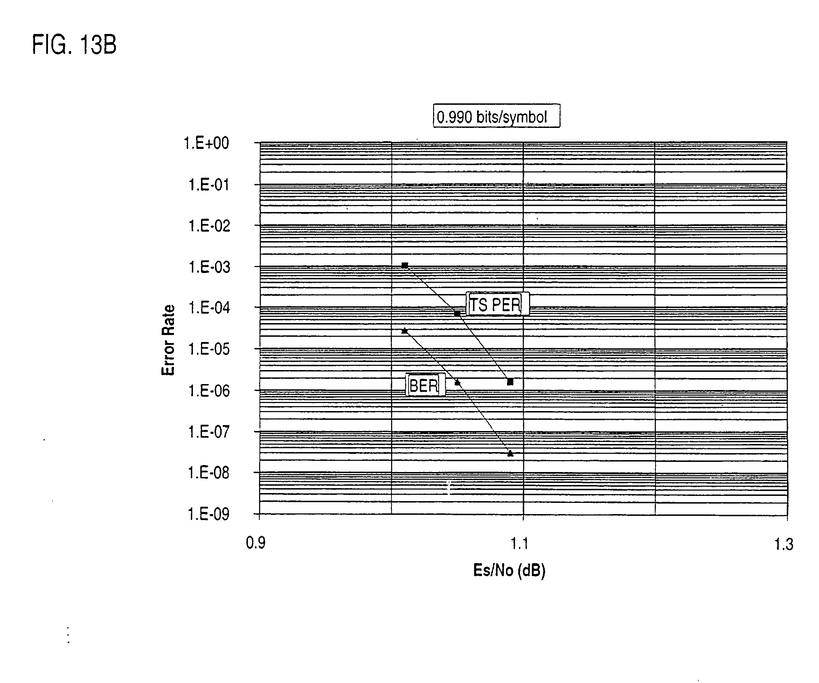

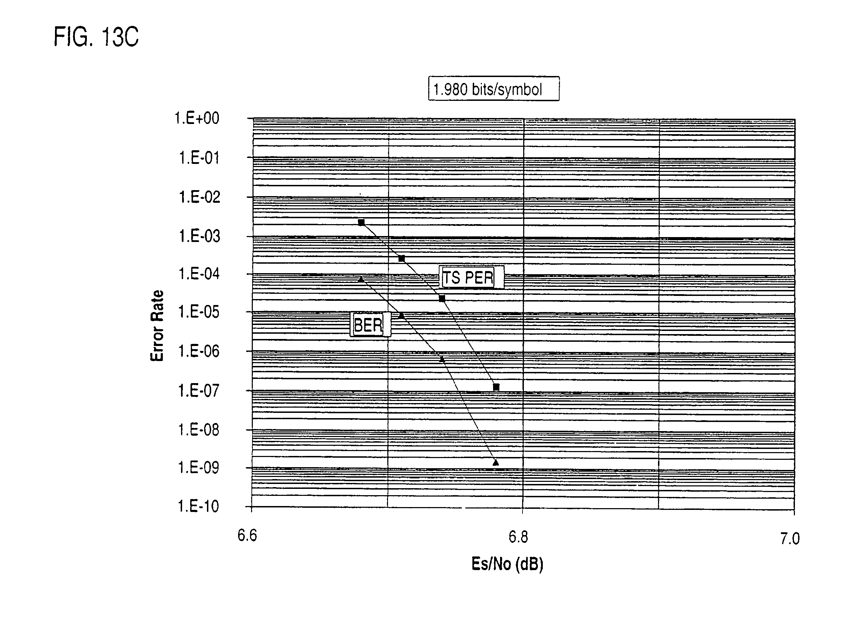

Per step 1007, it is determined whether all the parity check equations are satisfied. If these parity check equations are not satisfied, then the decoder 305, as in step 1009, re-derives 8-PSK bit metrics and channel input $u_n$. Next, the bit node is updated, as in step 1011. As shown in FIG. 13C, the incoming messages to the bit node $n$ from its $d_v$ adjacent check nodes are denoted by $w_{k_1 \to n}$ $w_{k_2 \to n}$,...., $w_{k_{dv} \to n}$ The outgoing messages from the bit node $n$ are computed back to $d_v$ adjacent check nodes; such messages are denoted by $V_{n \to k_1}$, $v_{n \to k_2}$ ,....,$v_{n \to k_{dv}}$, and computed as follows:

$$v_{n \to k_i} = u_n + \sum_{j \neq i} w_{k_j \to n}$$

In step 1013, the decoder 305 outputs the hard decision (in the case that all parity check equations are satisfied):

$$\hat{c}_n = \begin{cases} 0, & a_n \geq 0 \\ 1, & a_n < 0 \end{cases} \qquad \text{Stop if } H\hat{c}^T = 0$$

The above approach is appropriate when non-Gray labeling is utilized. However, when Gray labeling is implemented, the process of FIG. 11 is executed.

FIG. 11 is a flow chart of the operation of the LDPC decoder of FIG. 3 using Gray mapping, according to an embodiment of the present invention. When Gray labeling is used, bit metrics are advantageously generated only once before the LDPC decoder, as re-generating bit metrics after every LDPC decoder iteration may yield nominal performance improvement. As with steps 1001 and 1003 of FIG. 10, initialization of the log likelihood ratios of coded bits, $v$, are performed, and the check node is updated, per steps 1101 and 1103. Next, the bit node $n$ is updated, as in step 1105. Thereafter, the decoder outputs the *a posteriori* probability information (step 1107). In step 1109, a determination is made whether all of the parity check equations are satisfied; if so, the decoder outputs the hard decision (step 1111). Otherwise, steps 1103-1107 are repeated.

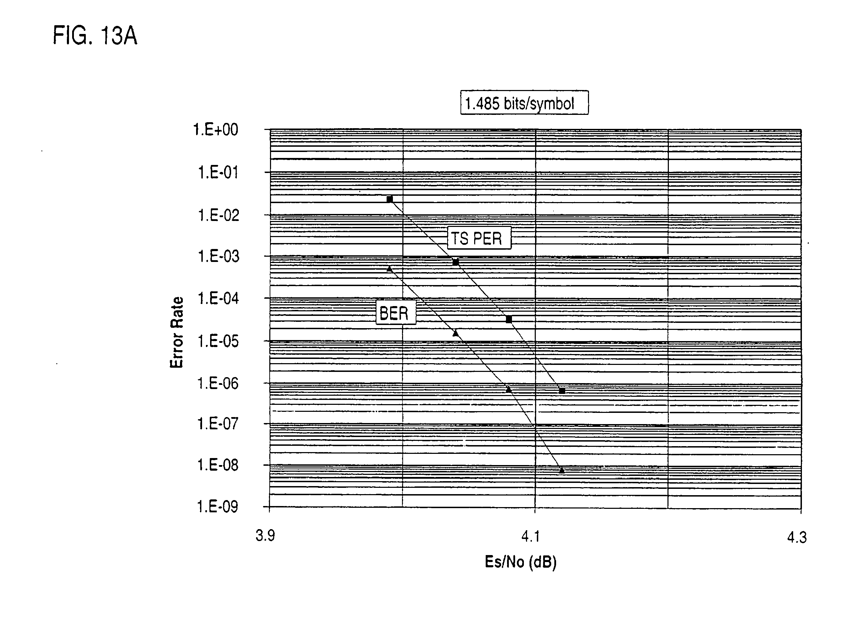

FIGs. 13A-13C are graphs showing simulation results of LDPC codes generated in accordance with various embodiments of the present invention. In particular, FIGS. 13A-13C show the performance of LDPC codes with higher order modulation and code rates of 3/4 (QPSK, 1.485 bits/symbol), 2/3 (8-PSK, 1.980 bits/symbol), and 5/6 (8-PSK, 2.474 bits/symbol).

Two general approaches exist to realize the interconnections between check nodes and bit nodes: (1) a fully parallel approach, and (2) a partially parallel approach. In fully parallel architecture, all of the nodes and their interconnections are physically implemented. The advantage of this architecture is speed.

The fully parallel architecture, however, may involve greater complexity in realizing all of the nodes and their connections. Therefore with fully parallel architecture, a smaller block size may be required to reduce the complexity. In that case, for the same clock frequency, a proportional reduction in throughput and some degradation in FER versus Es/No performance may result.

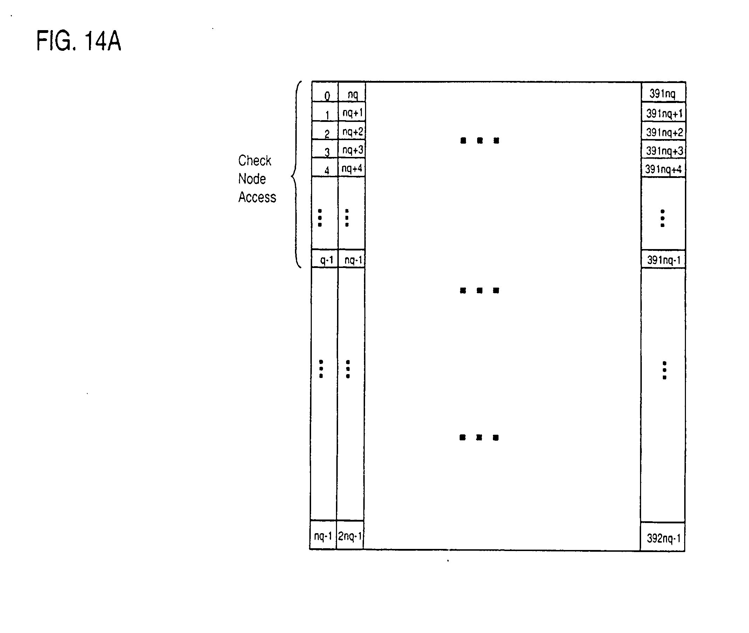

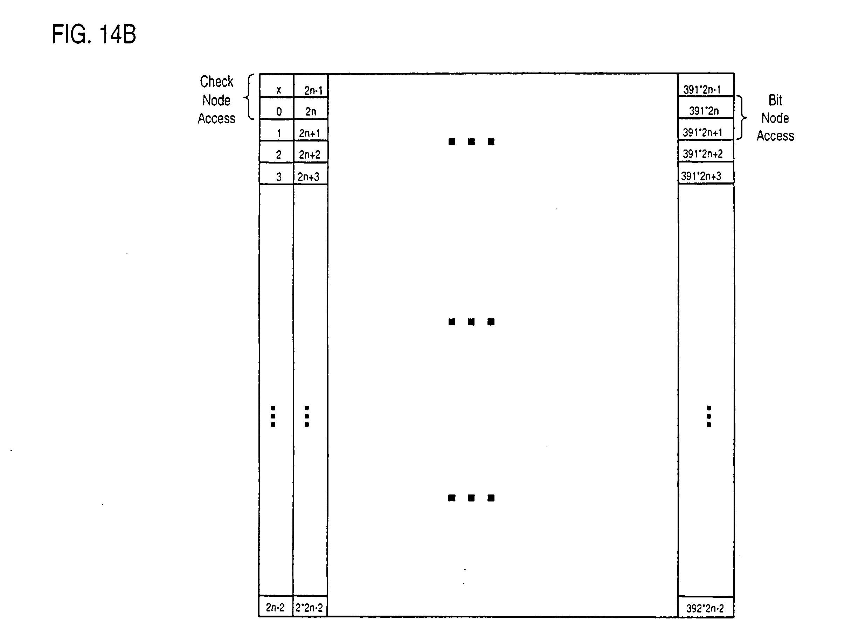

The second approach to implementing LDPC codes is to physically realize only a subset of the total number of the nodes and use only these limited number of "physical" nodes to process all of the "functional" nodes of the code. Even though the LDPC decoder operations can be made extremely simple and can be performed in parallel, the further challenge in the design is how the communication is established between "randomly" distributed bit nodes and check nodes. The decoder 305, of FIG. 3, according to one embodiment of the present invention, addresses this problem by accessing memory in a structured way, as to realize a seemingly random code. This approach is explained with respect to FIGs. 14A and 14B.

FIGs. 14A and 14B are diagrams of the top edge and bottom edge, respectively, of memory organized to support structured access as to realize randomness in LDPC coding, according to an embodiment of the present invention. Structured access can be achieved without compromising the performance of a truly random code by focusing on the generation of the parity check matrix. In general, a parity check matrix can be specified by the connections of the check nodes with the bit nodes. For example, the bit nodes are divided into groups of 392 (392 is provided for the purposes of illustration).. Additionally, assuming the check nodes connected to the first bit node of degree 3, for instance, are numbered as $a, b$ and $c$, then the check nodes connected to the second bit node are numbered as $a+p, b+p$ and $c+p$, the check nodes connected to the third bit node are numbered as $a+2p, b+2p$ and $c+2p$ etc. For the next group of 392 bit nodes, the check nodes connected to the first bit node are different from $a, b, c$ so that with a suitable choice of $p$, all the check nodes have the same degree. A random search is performed over the free constants such that the resulting LDPC code is cycle-4 and cycle-6 free.

The above arrangement facilitates memory access during check node and bit node processing. The values of the edges in the bipartite graph can be stored in a storage medium, such as random access memory (RAM). It is noted that for a truly random LDPC code during check node and bit node processing, the values of the edges would need to be accessed one by one in a random fashion. However, such an access scheme would be too slow for a high data rate application. The RAM of FIGs. 14A and 14B are organized in a manner, whereby a large group of relevant edges in one clock cycle; accordingly, these values are placed "together" in memory. It is observed that, in actuality, even with a truly random code, for a group of check nodes (and respectively bit nodes), the relevant edges can be placed next to one another in RAM, but then the relevant edges adjacent to a group of bit nodes (respectively check nodes) will be randomly scattered in RAM. Therefore, the "togetherness," under the present invention, stems from the design of the parity check matrices themselves. That is, the check matrix design ensures that the relevant edges for a group of bit nodes and check nodes are simultaneously placed together in RAM.

As seen in FIGs. 14A and 14B, each box contains the value of an edge, which is multiple bits (e.g., 6). Edge RAM, according to one embodiment of the present invention, is divided into two parts: top edge RAM (FIG. 14A) and bottom edge RAM (FIG. 14B). Bottom edge RAM contains the edges between bit nodes of degree 2, for example, and check nodes. Top edge RAM contains the edges between bit nodes of degree greater than 2 and check nodes. Therefore, for every check node, 2 adjacent edges are stored in the bottom RAM, and the rest of the edges are stored in the top edge RAM.

Continuing with the above example, a group of 392 bit nodes and 392 check nodes are selected for processing at a time. For 392 check node processing, q consecutive rows are accessed from the top edge RAM, and 2 consecutive rows from the bottom edge RAM. In this instance, $q+2$ is the degree of each check node. For bit node processing, if the group of 392 bit nodes has degree 2, their edges are located in 2 consecutive rows of the bottom edge RAM. If the bit nodes have degree $d > 2$, their edges are located in some $d$ rows of the top edge RAM. The address of these $d$ rows can be stored in non-volatile memory, such as Read-Only Memory (ROM). The edges in one of the rows correspond to the first edges of 392 bit nodes, the edges in another row correspond to the second edges of 392 bit nodes, etc. Moreover for each row, the column index of the edge that belongs to the first bit node in the group of 392 can also be stored in ROM. The edges that correspond to the second, third, etc. bit nodes follow the starting column index in a "wrapped around" fashion. For example, if the $j^{th}$ edge in the row belongs to the first bit node, then the $(j+1)$st edge belongs to the second bit node, $(j+2)$nd edge belongs to the third bit node, ...., and $(j-1)$st edge belongs to the $392^{th}$ bit node.

With the above organization (shown in FIGs. 14A and 14B), speed of memory access is greatly enhanced during LDPC coding.

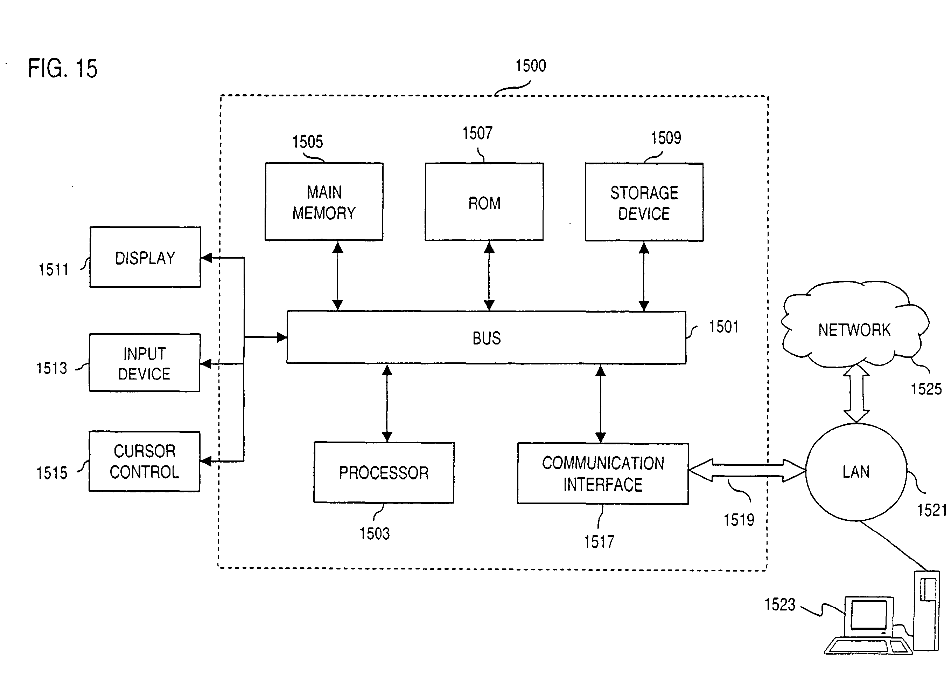

FIG. 15 illustrates a computer system 1500 upon which an embodiment according to the present invention can be implemented. The computer system 1500 includes a bus 1501 or other communication mechanism for communicating information, and a processor 1503 coupled to the bus 1501 for processing information. The computer system 1500 also includes main memory 1505, such as a random access memory (RAM) or other dynamic storage device, coupled to the bus 1501 for storing information and instructions to be executed by the processor 1503. Main memory 1505 can also be used for storing temporary variables or other intermediate information during execution of instructions to be executed by the processor 1503. The computer system 1500 further includes a read only memory (ROM) 1507 or other static storage device coupled to the bus 1501 for storing static information and instructions for the processor 1503. A storage device 1509, such as a magnetic disk or optical disk, is additionally coupled to the bus 1501 for storing information and instructions.

The computer system 1500 may be coupled via the bus 1501 to a display 1511, such as a cathode ray tube (CRT), liquid crystal display, active matrix display, or plasma display, for displaying information to a computer user. An input device 1513, such as a keyboard including alphanumeric and other keys, is coupled to the bus 1501 for communicating information and command selections to the processor 1503. Another type of user input device is cursor control 1515, such as a mouse, a trackball, or cursor direction keys for communicating direction information and command selections to the processor 1503 and for controlling cursor movement on the display 1511.

According to one embodiment of the invention, generation of LDPC codes is provided by the computer system 1500 in response to the processor 1503 executing an arrangement of instructions contained in main memory 1505. Such instructions can be read into main memory 1505 from another computer-readable medium, such as the storage device 1509. Execution of the arrangement of instructions contained in main memory 1505 causes the processor 1503 to perform the process steps described herein. One or more processors in a multi-processing arrangement may also be employed to execute the instructions contained in main memory 1505. In alternative embodiments, hard-wired circuitry may be used in place of or in combination with software instructions to implement the embodiment of the present invention. Thus, embodiments of the present invention are not limited to any specific combination of hardware circuitry and software.

The computer system 1500 also includes a communication interface 1517 coupled to bus 1501. The communication interface 1517 provides a two-way data communication coupling to a network link 1519 connected to a local network 1521. For example, the communication interface 1517 may be a digital subscriber line (DSL) card or modem, an integrated services digital network (ISDN) card, a cable modem, or a telephone modem to provide a data communication connection to a corresponding type of telephone line. As another example, communication interface 1517 may be a local area network (LAN) card (e.g. for Ethernet$^{TM}$ or an Asynchronous Transfer Model (ATM) network) to provide a data communication connection to a compatible LAN. Wireless links can also be implemented. In any such implementation, communication interface 1517 sends and receives electrical, electromagnetic, or optical signals that carry digital data streams representing various types of information. Further, the communication interface 1517 can include peripheral interface devices, such as a Universal Serial Bus (USB) interface, a PCMCIA (Personal Computer Memory Card International Association) interface, etc.

The network link 1519 typically provides data communication through one or more networks to other data devices. For example, the network link 1519 may provide a connection through local network 1521 to a host computer 1523, which has connectivity to a network 1525 (e.g. a wide area network (WAN) or the global packet data communication network now commonly referred to as the "Internet") or to data equipment operated by service provider. The local network 1521 and network 1525 both use electrical, electromagnetic, or optical signals to convey information and instructions. The signals through the various networks and the signals on network link 1519 and through communication interface 1517, which communicate digital data with computer system 1500, are exemplary forms of carrier waves bearing the information and instructions.

The computer system 1500 can send messages and receive data, including program code, through the network (s), network link 1519, and communication interface 1517. In the Internet example, a server (not shown) might transmit requested code belonging to an application program for implementing an embodiment of the present invention through the network 1525, local network 1521 and communication interface 1517. The processor 1503 may execute the transmitted code while being received and/or store the code in storage device 159, or other non-volatile storage for later execution. In this manner, computer system 1500 may obtain application code in the form of a carrier wave.

The term "computer-readable medium" as used herein refers to any medium that participates in providing instructions to the processor 1503 for execution. Such a medium may take many forms, including but not limited to non-volatile media, volatile media, and transmission media. Non-volatile media include, for example, optical or magnetic disks, such as storage device 1509. Volatile media include dynamic memory, such as main memory 1505. Transmission media include coaxial cables, copper wire and fiber optics, including the wires that comprise bus 1501. Transmission media can also take the form of acoustic, optical, or electromagnetic waves, such as those generated during radio frequency (RF) and infrared (IR) data communications. Common forms of computer-readable media include, for example, a floppy disk, a flexible disk, hard disk, magnetic tape, any other magnetic medium, a CD-ROM, CDRW, DVD, any other optical medium, punch cards, paper tape, optical mark sheets, any other physical medium with patterns of holes or other optically recognizable indicia, a RAM, a PROM, and EPROM, a FLASH-EPROM, any other memory chip or cartridge, a carrier wave, or any other medium from which a computer can read.

Various forms of computer-readable media may be involved in providing instructions to a processor for execution. For example, the instructions for carrying out at least part of the present invention may initially be borne on a magnetic disk of a remote computer. In such a scenario, the remote computer loads the instructions into main memory and sends the instructions over a telephone line using a modem. A modem of a local computer system receives the data on the telephone line and uses an infrared transmitter to convert the data to an infrared signal and transmit the infrared signal to a portable computing device, such as a personal digital assistance (PDA) and a laptop. An infrared detector on the portable computing device receives the information and instructions borne by the infrared signal and places the data on a bus. The bus conveys the data to main memory, from which a processor retrieves and executes the instructions. The instructions received by main memory may optionally be stored on storage device either before or after execution by processor.

Accordingly, the various embodiments of the present invention provide an approach for generating structured Low Density Parity Check (LDPC) codes, as to simplify the encoder and decoder. Structure of the LDPC codes is provided by restricting the parity check matrix to be lower triangular. Also, the approach can advantageously exploit the unequal error protecting capability of LDPC codes on transmitted bits to provide extra error protection to more vulnerable bits of high order modulation constellations (such as 8-PSK (Phase Shift Keying)). Additionally, the parity check matrix can be algorithmically generated using pre-stored constants and bitwise operations. Efficient decoding of the LDPC can be achieved by storing information representing consecutive edges from the check nodes to the bit nodes of the parity check matrix in consecutive slots of memory. The above approach advantageously yields reduced complexity without sacrificing performance.

While the present invention has been described in connection with a number of embodiments and implementations, the present invention is not so limited but covers various obvious modifications and equivalent arrangements, which fall within the purview of the appended claims.

**Claims**

1.  A method for generating a low density parity check (LDPC) code, the method comprising:

    transforming a received input message into an LDPC codeword using only a parity check matrix of the LDPC code without using a generator matrix of the LDPC code; and
    outputting the LDPC codeword,
    wherein the parity check matrix specifies the connections of check nodes with bit nodes,
    wherein the bit nodes are divided into groups of $M$ bit nodes,
    wherein, for each group of bit nodes, each bit node $n_j$ is connected to check nodes numbered $m_1 + jp$, $m_2 + jp$, ... , $m_d + jp$, where $j = 0$ to M-1 represents the numbering of the bit nodes in said group and $m_1, m_2, ... , m_d$ represents the $d$ check nodes connected to the first bit node in each group , the check nodes $m_1, m_2, ..., m_d$ being different from one group of bit nodes to the next group of bit nodes, so that with a suitable value of $p$, all the check nodes represented in the matrix have the same degree,
    such that the parity check matrix provides for structured access during decoding of the LDPC codeword through placing edge values for a group of bit nodes next to one another in memory and simultaneously placing edge values for a group of check nodes next to one another in the memory.

2.  A method according to claim 1, wherein a predetermined triangular portion of the parity check matrix in the transforming step has zero values after row or column permutation.

3.  A method according to claim 1, further comprising:

    modulating LDPC codeword according to a modulation scheme including one of 8-PSK Phase Shift Keying, 16-QAM Quadrature Amplitude Modulation, and QPSK Quadrature Phase Shift Keying.

4.  A computer-readable medium bearing instructions for generating LDPC codes, said instructions, being arranged, upon execution, to cause one or more processors to perform the method of claim 1.

5.  A method according to claim 1, further comprising applying an outer code to the LDPC code, wherein the outer code in the applying step includes one of a Bose, Chaudhuri, and Hocquenghem BCH code, a Reed-Solomon RS code, and a Hamming code.

6.  A method according to claim 1, wherein the memory has a first portion containing edge values adjacent to bit nodes of degree 2, and a second portion containing edge values adjacent to bit nodes of degree greater than 2.

7.  A system (200) for generating a low density parity check (LDPC) code, the system (200) comprising:

means (203) for transforming a received input message into a LDPC codeword using only a parity check matrix of the LDPC code without using a generator matrix of the LDPC code; and

means for outputting the LDPC codeword,

wherein the parity check matrix specifies the connections of check nodes with bit nodes,

wherein the bit nodes are divided into groups of *M* bit nodes,

wherein, for each group of bit nodes, each bit node $n_j$ is connected to check nodes numbered $m_1 + jp$, $m_2 + jp$, ... , $m_d + jp$, where $j = 0$ to $M-1$ represents the numbering of the bit nodes in said group and $m_1, m_2, ... , m_d$ represents the $d$ check nodes connected to the first bit node in each group , the check nodes $m_1, m_2, ... , m_d$ being different from one group of bit nodes to the next group of bit nodes, so that with a suitable value of *p*, all the check nodes represented in the matrix have the same degree,

such that the parity check matrix provides for structured access during decoding of the LDPC codeword through placing edge values for a group of bit nodes next to one another in memory and simultaneously placing edge values for a group of check nodes next to one another in the memory.

8. A system (200) according to claim 7, wherein a predetermined triangular portion of the parity check matrix has zero values after row or column permutation.

9. A system (200) according to claim 7, wherein the LDPC codeword is modulated according to a modulation scheme including one of 8-PSK Phase Shift Keying, 16-QAM Quadrature Amplitude Modulation, and QPSK Quadrature Phase Shift Keying.

**Patentansprüche**

1. Verfahren zum Erzeugen eines Low-Density-Parity-Check-Codes (LDPC-Code), wobei das Verfahren umfasst:

das Umwandeln einer empfangenen Eingangsnachricht in ein LDPC-Codewort unter Verwendung nur einer Paritätskontrollmatrix des LDPC-Codes ohne Verwenden einer Generatormatrix des LDPC-Codes, und Ausgeben des LDPC-Codewortes,

wobei die Paritätskontrollmatrix die Verbindungen von Check-Knoten mit Bit-Knoten festlegt,

wobei die Bit-Knoten in Gruppen von M Bit-Knoten unterteilt sind,

wobei für jede Gruppe von Bit-Knoten jeder Bit-Knoten $n_j$ verbunden ist mit Check-Knoten, die mit $m_1+jp$, $m_2+jp$, ..., $m_d+jp$ nummeriert sind, wobei $j = 0$ bis $M-1$ die Nummerierung der Bit-Knoten in den Gruppen wiedergibt und $m_1, m_2, ..., m_d$ die mit dem ersten Bit-Knoten in jeder Gruppe verbundenen d Check-Knoten wiedergibt, wobei die Check-Knoten $m_1, m_2, ..., m_d$ von einer Gruppe von Bit-Knoten zu der nächsten Gruppe von Bit-Knoten verschieden sind, so dass mit einem geeigneten Wert von p alle in der Matrix wiedergegebenen Check-Knoten den gleichen Grad besitzen,

so dass die Paritätskontrollmatrix für einen strukturierten Zugriff sorgt während des Dekodierens des LDPC-Codewortes durch Anordnen von Kantenwerten für eine Gruppe von in einem Speicher zueinander benachbarten Bit-Knoten und gleichzeitiges Anordnen von Kantenwerten für eine Gruppe von in dem Speicher zueinander benachbarten Check-Knoten.

2. Verfahren nach Anspruch 1, wobei ein vorbestimmter dreieckiger Abschnitt der Paritätskontrollmatrix in dem Umwandlungsschritt Null-Werte nach Zeilen- oder Spaltenpermutation hat.

3. Verfahren nach Anspruch 1, das weiter umfasst:

das Modulieren des LDPC-Codewortes gemäß einem Modulationsschema einschließlich einer 8-PSK-Phasenumtastung, einer 16-QAM-Quadraturamplitudenmodulation und einer QPSK-Quadraturphasenumtastung.

4. Computerlesbares Medium, das Anweisungen trägt zum Erzeugen von LDPC-Codes, wobei die Anweisungen so angelegt sind, dass sie nach Ausführung bewirken, dass ein oder mehrere Prozessoren das Verfahren nach Anspruch 1 ausführen.

5. Verfahren nach Anspruch 1, das weiter einen äußeren Code auf den LDPC-Code anwendet, wobei der äußere Code in dem Anwendungsschritt einen von einem Bose-, Chaudhuri- und Hocquenghem-BCH-Code, einem Reed-Solomon-RS-Code und einem Hamming-Code einschließt.

**6.** Verfahren nach Anspruch 1, wobei der Speicher einen ersten Abschnitt, der Kantenwerte benachbart zu Bit-Knoten vom Grad 2 enthält, und einen zweiten Abschnitt hat, der Kantenwerte benachbart zu Bit-Knoten vom Grad größer als 2 enthält.

**7.** System (200) zum Erzeugen eines Low-Density-Parity-Check-Codes (LDPC-Code), wobei das System (200) umfasst:

Mittel (203) zum Umwandeln einer empfangenen Eingangsnachricht in ein LDPC-Codewort unter Verwendung nur einer Paritätskontrollmatrix des LDPC-Codes ohne eine Generatormatrix des LDPC-Codes zu verwenden; und

Mittel zum Ausgeben des LDPC-Codewortes,

wobei die Paritätskontrollmatrix die Verbindungen der Check-Knoten mit den Bit-Knoten festlegt,

wobei die Bit-Knoten in Gruppen von M Bit-Knoten unterteilt sind,

wobei für jede Gruppe von Bit-Knoten jeder Bit-Knoten $n_j$ verbunden ist mit Check-Knoten, die mit $m_1+jp$, $m_2+jp$, ..., $m_d+jp$ nummeriert sind, wobei $j = 0$ bis $M-1$ die Nummerierung der Bit-Knoten in der Gruppe wiedergibt und $m_1, m_2, ..., m_d$ die mit dem ersten Bit-Knoten in jeder Gruppe verbundenen d Check-Knoten wiedergibt, wobei die Check-Knoten $m_1, m_2, ..., m_d$ von einer Gruppe von Bit-Knoten zu der nächsten Gruppe von Bit-Knoten verschieden sind, so dass mit einem geeigneten Wert von p alle in der Matrix wiedergegebenen Check-Knoten den gleichen Grad besitzen,

so dass die Paritätskontrollmatrix für einen strukturierten Zugriff während des Dekodierens des LDPC-Codewortes sorgt durch Anordnen von Kantenwerten für eine Gruppe von Bit-Knoten, die in einem Speicher zueinander benachbart sind, und gleichzeitiges Anordnen von Kantenwerten für eine Gruppe von Check-Knoten, die in dem Speicher zueinander benachbart sind.

**8.** System (200) nach Anspruch 7, wobei ein vorbestimmter dreieckiger Abschnitt der Paritätskontrollmatrix nach Zeilen- oder Spaltenpermutation Null-Werte hat.

**9.** System (200) nach Anspruch 7, wobei das LDPC-Codewort moduliert ist gemäß einem Modulationsschema, das eines von einer 8-PSK-Phaseumtastung, einer 16-QAM-Quadraturamplitudenmodulation und einer QPSK-Quadraturphasenumtastung einschließt.

## Revendications

**1.** Procédé de production d'un code de vérification de parité à faible densité (LDPC pour *Low Density Parity Check*), le procédé comprenant les étapes consistant à :

transformer un message d'entrée reçu en un mot de code LDPC en utilisant seulement une matrice de vérification de parité du code LDPC, sans utiliser une matrice de génération du code LDPC, et

fournir en sortie le mot de code LDPC,

dans lequel la matrice de vérification de parité spécifie les connexions entre des noeuds de vérification et des noeuds de bits,

dans lequel les noeuds de bits sont divisés en groupes de M noeuds de bits,

dans lequel, pour chaque groupe de noeuds de bits, chaque noeud de bit $n_j$ est connecté à des noeuds de vérification numérotés $m_1 + jp$, $m_2 + jp$, ..., $m_d + jp$, où $j = 0$ à $M-1$ et représente la numérotation des noeuds de bits dans ledit groupe et $m_1, m_2, ..., m_d$ représentent les d noeuds de vérification connectés au premier noeud de bit de chaque groupe, les noeuds de vérification $m_1, m_2, ..., m_d$ étant différents d'un groupe de noeuds de bits au groupe suivant de noeuds de bits, si bien que, avec une valeur adéquate de p, tous les noeuds de vérification représentés dans la matrice ont le même degré,

si bien que la matrice de vérification de parité offre un accès structuré, pendant le décodage du mot de code LDPC, en plaçant des valeurs de bord d'un groupe de noeuds de bits les unes à côté des autres en mémoire et simultanément en plaçant des valeurs de bord d'un groupe de noeuds de vérification les unes à côté des autres dans la mémoire.

**2.** Procédé selon la revendication 1, dans lequel, dans l'étape de transformation, une portion triangulaire prédéterminée de la matrice de vérification de parité a des valeurs nulles après la permutation des rangées ou des colonnes.

**3.** Procédé selon la revendication 1, comprenant en outre l'étape consistant à :

moduler le mot de code LDPC en utilisant un schéma de modulation comprenant l'un des suivants : modulation à déplacement de phase 8-PSK (*Phase Shift Keying*), modulation d'amplitude en quadrature 16-QAM *(Quadrature Amplitude Modulation)* et modulation par quadrature de phase QPSK *(Quadrature Phase Shift Keying).*

4. Support lisible par ordinateur portant des instructions destinées à produire des codes LDPC, lesdites instructions étant conçues, lors de leur exécution, pour faire exécuter par un ou plusieurs processeurs le procédé selon la revendication 1.

5. Procédé selon la revendication 1, comprenant en outre l'étape consistant à appliquer un code extérieur au code LDPC, le code extérieur utilisé dans l'étape d'application comprenant soit un code BCH (pour code de Bose, Chaudhuri et Hocquenghem), soit un code RS (code de Reed-Solomon), soit un code de Hamming.

6. Procédé selon la revendication 1, dans lequel la mémoire possède une première portion contenant des valeurs de bord adjacentes à des noeuds de bits de degré 2 et une seconde portion contenant des valeurs de bord adjacentes à des noeuds de bits de degré supérieur à 2.

7. Système (200) destiné à produire un code LDPC (pour « *Low Density Parity Check* »), le système (200) comprenant :

   un moyen (203) destiné à transformer un message d'entrée reçu en un mot de code LDPC en utilisant seulement une matrice de vérification de parité du code LDPC, sans utiliser une matrice de génération du code LDPC, et un moyen destiné à fournir en sortie le mot de code LDPC,
   dans lequel la matrice de vérification de parité spécifie les connexions entre des noeuds de vérification et des noeuds de bits,
   dans lequel les noeuds de bits sont divisés en groupes de M noeuds de bits,
   dans lequel, pour chaque groupe de noeuds de bits, chaque noeud de bit $n_j$ est connecté à des noeuds de vérification numérotés $m_1 + jp$, $m_2 + jp$, ..., $m_d + jp$, où $j = 0$ à M-1 représente la numérotation des noeuds de bits dans ledit groupe et $m_1$, $m_2$, ..., $m_d$ représentent les d noeuds de vérification connectés au premier noeud de bit de chaque groupe, les noeuds de vérification $m_1$, $m_2$, ..., $m_d$ étant différents d'un groupe de noeuds de bits au groupe suivant de noeuds de bits, si bien que, avec une valeur adéquate de p, tous les noeuds de vérification représentés dans la matrice ont le même degré,
   si bien que la matrice de vérification de parité offre un accès structuré, pendant le décodage du mot de code LDPC, en plaçant des valeurs de bord d'un groupe de noeuds de bits les unes à côté des autres en mémoire et simultanément en plaçant des valeurs de bord d'un groupe de noeuds de vérification les unes à côté des autres dans la mémoire.

8. Système (200) selon la revendication 7, dans lequel une portion triangulaire prédéterminée de la matrice de vérification de parité a des valeurs nulles après la permutation des rangées ou des colonnes.

9. Système (200) selon la revendication 7, dans lequel le mot de code LDPC est modulé selon un schéma de modulation comprenant l'un des suivants : 8-PSK (pour *Phase Shift Keying*), 16-QAM (pour *Quadrature Amplitude Modulation)* et QPSK (pour *Quadrature Phase Shift Keying*).

FIG. 1

100

EP 1 385 270 B1

101

103

105

```
┌─────────────────┐         ┌─────────────────┐         ┌─────────────────┐
│                 │         │                 │         │                 │
│   TRANSMITTER   │────────▶│     CHANNEL     │────────▶│    RECEIVER     │
│                 │         │                 │         │                 │
└─────────────────┘         └─────────────────┘         └─────────────────┘
```

FIG. 2

TRANSMITTER 200

X → | SOURCE 201 | →k→ | LDPC ENCODER 203 | →Y→ | MODULATOR 205 | → 207

RECEIVER 300

303 → | DEMODULATOR 301 | →Y'
| BIT METRIC GENERATOR 307 |
| LDPC DECODER 305 | → X'

FIG. 3

EP 1 385 270 B1

FIG. 4

$$H = \begin{bmatrix} 1 & 0 & 0 & 1 & 1 & 0 & 0 & 1 \\ 0 & 1 & 1 & 0 & 1 & 0 & 1 & 0 \\ 1 & 0 & 1 & 0 & 0 & 1 & 0 & 1 \\ 0 & 1 & 0 & 1 & 0 & 1 & 1 & 0 \end{bmatrix} \begin{matrix} m_1 \\ m_2 \\ m_3 \\ m_4 \end{matrix}$$

$n_1$ $n_2$ $n_3$ $n_4$ $n_5$ $n_6$ $n_7$ $n_8$

FIG. 5

bit nodes

check nodes

$$B = \begin{bmatrix} 1 & & & & & \\ x & 1 & & & & \\ x & x & 1 & & \mathbf{0} & \\ x & x & x & 1 & & \\ x & x & x & x & 1 & \\ x & x & x & x & x & 1 \end{bmatrix}$$

FIG. 6

EP 1 385 270 B1

FIG. 7

FIG. 8A

010 $s_2$ ○  
$s_1$ ○ 001  
$s_0$ ○ 000  
$s_5$ ○ 101  
011 ○ $s_3$  
110 ○ $s_6$  
111 ○ $s_7$  
$s_4$ ○  
100

FIG. 8B

010 $s_2$ ○  
$s_1$ ○ 001  
$s_0$ ○ 000  
$s_5$ ○ 101  
011 ○ $s_3$  
111 ○ $s_7$  
110 ○ $s_6$  
$s_4$ ○  
100

FIG. 9

**FIG. 10**

```
                    ┌─────────┐
                    │  START  │
                    └─────────┘
                         │
                         ▼
              ┌──────────────────────┐
  1001 ──     │ PERFORM INITIALIZATION│
              └──────────────────────┘
                         │
                         ▼
              ┌──────────────────────┐
  1003 ──     │   UPDATE CHECK NODE  │◄──────────────┐
              └──────────────────────┘               │
                         │                            │
                         ▼                            │
              ┌──────────────────────┐               │
  1005 ──     │       OUTPUT         │               │
              │    A POSTERIORI      │               │
              └──────────────────────┘               │
                         │                            │
      1007 ──            ▼                            │
              ╱──────────────────────╲               │
     YES     ╱     ALL PARITY         ╲    NO    ┌──────────────────────┐
   ◄────────╱    CHECK EQUATIONS       ╲────────►│  RE-DERIVE 8-PSK BIT │
            ╲     SATISFIED?           ╱         │  METRICS AND CHANNEL │
             ╲──────────────────────╱           │       INPUT          │
              │                          1011 ── └──────────────────────┘
              ▼                                             │
  ┌──────────────────────┐                                 ▼
  │ OUTPUT HARD DECISION  │                     ┌──────────────────────┐
  └──────────────────────┘            1013 ──   │   UPDATE BIT NODE    │
1009          │                                 └──────────────────────┘
              ▼
        ┌─────────┐
        │   END   │
        └─────────┘
```

EP 1 385 270 B1

FIG. 11

START

1101 — PERFORM INITIALIZATION

1103 — UPDATE CHECK NODE

1105 — UPDATE BIT NODE

1107 — OUTPUT
*A POSTERIORI*

1109 — ALL PARITY
CHECK EQUATIONS
SATISFIED?

YES

NO

1111 — OUTPUT HARD DECISION

END

EP 1 385 270 B1

22

EP 1 385 270 B1

## FIG. 12A

$v_{n\to k_1} = u_n$

$v_{n\to k_2} = u_n$

Bit node n

$v_{n\to k_i} = u_n$

## FIG. 12B

$w_{k\to n_1}$

$w_{k\to n_2}$

$v_{n_1\to k}$

$w_{k\to n_3}$

$v_{n_2\to k}$

$v_{n_3\to k}$

Check node k

$v_{n_{dc}\to k}$

$w_{k\to n_{dc}}$

$$w_{k\to n_i} = g\left(v_{n_1\to k}, v_{n_2\to k}, \ldots, v_{n_{i-1}\to k}, v_{n_{i+1}\to k}, \ldots, v_{n_{dc}\to k}\right)$$

## FIG. 12C

$v_{n\to k_1}$

$w_{k_1\to n}$

Bit node n

$v_{n\to k_2}$

$w_{k_2\to n}$

$w_{k_3\to n}$

$v_{n\to k_3}$

$w_{k_{dv}\to n}$

$v_{n\to k_{dv}}$

$$v_{n\to k_i} = u_n + \sum_{j\neq i} w_{k_j\to n}$$

FIG. 13A

# FIG. 13B

0.990 bits/symbol

Error Rate vs Es/No (dB)

FIG. 13C

1.980 bits/symbol

Error Rate

1.E+00
1.E-01
1.E-02
1.E-03
1.E-04
1.E-05
1.E-06
1.E-07
1.E-08
1.E-09
1.E-10

TS PER

BER

6.6          6.8          7.0

Es/No (dB)

EP 1 385 270 B1

## FIG. 14A

| 0 | nq | 391nq |
| 1 | nq+1 | 391nq+1 |
| 2 | nq+2 | 391nq+2 |
| 3 | nq+3 | 391nq+3 |
| 4 | nq+4 | 391nq+4 |
| ... | ... | ... |
| q-1 | nq-1 | 391nq-1 |
| ... | ... | ... |
| nq-1 | 2nq-1 | 392nq-1 |

Check Node Access

EP 1 385 270 B1

## FIG. 14B

## FIG. 15

FIG. 15

1500

1505 MAIN MEMORY

1507 ROM

1509 STORAGE DEVICE

1511 DISPLAY

1513 INPUT DEVICE

1515 CURSOR CONTROL

1501 BUS

1503 PROCESSOR

1517 COMMUNICATION INTERFACE

1519

1521 LAN

1525 NETWORK

1523

EP 1 385 270 B1